# EUROPÄISCHE PATENTANMELDUNG

(11) **EP 3 657 914 A1**
(43) Veröffentlichungstag der Anmeldung: **27.05.2020**
(21) Anmeldenummer: 19210656.5
(22) Anmeldetag: 21.11.2019
(51) Int. Cl.: H05K 1/11, H05K 3/24, H05K 3/34, H05K 3/28

(54) **LEITERPLATTE FÜR EIN LED-MODUL, LED-MODUL SOWIE VERFAHREN ZUR HERSTELLUNG DERSELBEN**

(30) Priorität: 21.11.2018 DE 102018129358
(71) Anmelder: Siteco GmbH, 83301 Traunreut (DE)
(72) Erfinder: Wimmer, Kilian, 83362 Surberg (DE); Wuppinger, Bernhard, 83362 Surberg (DE)
(74) Vertreter: Schmidt, Steffen

(57) **Zusammenfassung**

Eine Leiterplatte (100, 101) für ein LED-Modul umfasst ein Trägerelement (10), eine auf dem Trägerelement (10) angeordnete und in Leiterbahnen (13a, 13b) strukturierte Aluminiumbeschichtung (12), und einen Lötstopplack (16), der auf oder oberhalb der Aluminiumbeschichtung (12) angeordnet ist und in welchem wenigstens ein Fenster (17) zur Bereitstellung eines Lötpads (18') ausgebildet ist. Dazu ist ein Zinnüberzug (20, 30) vorgesehen, der innerhalb des Fensters (17) im Lötstopplack (16) oder vollflächig unterhalb des Lötstopplacks (16) unmittelbar auf der Aluminiumbeschichtung (12) angeordnet und als Lötpad (18') zur Aufnahme einer Lotpaste (22) oder eines Lötzinns für die Kontaktierung oberflächenmontierbarer Bauelemente (26) während der Herstellung ausgebildet ist.

## Beschreibung

### Technisches Gebiet

Die vorliegende Erfindung betrifft eine Leiterplatte für ein LED-Modul, sowie das LED-Modul und ein Verfahren zur Herstellung der Leiterplatte.

### Stand der Technik

Leiterplatten, auch als Printed Circuit Boards (PCB) bezeichnet, werden üblicherweise als Träger für elektronische Bauelemente verwendet, die sie mechanisch fixieren und untereinander in geeigneter Weise elektronisch verbinden, und dadurch eine elektrische Schaltungsanordnung aufbauen. Handelsübliche LED-Module weisen dazu ebenfalls Leiterplatten auf, wobei die LEDs (Licht emittierende Dioden) sowie die ihnen zugeordneten weiteren elektronischen Bauelemente wie etwa Widerstände oder Kondensatoren sowie Transistoren zur Ausbildung von Stromreglern etc. über Leiterbahnen auf der Leiterplatte abhängig von einem vorgegebenen Layout miteinander verdrahtet sind. Leiterplatten für LED-Module können im Wesentlichen starr oder auch flexibel sein, wobei insbesondere Letzteres eine anpassungsfähige Unterbringung in Gehäusen oder Behältnissen beliebiger Art ermöglicht, beispielsweise in den schlauchartigen Hüllen biegsamer LED-Bänder, aber auch in oder an Leuchtenträgern unterschiedlichster Größen. Allgemein relevante Gesichtspunkte für Leiterplatten sind hier weiter die Abführung der durch die LEDs und insbesondere weiterer Komponenten erzeugten Wärme und die mechanische Fixierung im Gehäuse oder dem Leuchtenträger.

Im Allgemeinen weisen Leiterplatten ein zumeist flächenartig ausgebildetes Trägerelement auf, das aus einem elektrisch isolierenden Material gebildet ist. Übliche Materialien hierfür sind mit Epoxidharz getränkte Glasfasergewebe, wobei sich aktuelle eine Art Standard im Hinblick auf die Materialkennung FR4 herausgebildet hat. Gleichwohl gibt es auch Abweichungen davon, wenn z.B. höhere Werte für die Erweichungs- oder maximalen Betriebstemperaturen verlangt sind, oder wenn andere Dielektrizitätszahlen erforderlich scheinen. Gleiches gilt für die Realisierung einer verbesserten Wärmeleitung. Keramiken oder spezielle wärmeleitende Schichten können dazu eingefügt sein.

Die betreffenden Schaltungsanordnungen werden durch Leiterbahnen auf dem Trägerelement realisiert. Die Herstellung erfolgt üblich durch vollflächiges Auftragen z.B. einer Kupferschicht (mit einer Dicke z.B. 35 µm), gefolgt von photolithografischen Schritten einschließlich des Auftragens eines Resists, Belichten des Resits gemäß einem vorgegebenen Layout für die Schaltungsanordnung, Entwickeln und Entfernen der belichteten oder nichtbelichteten Abschnitte, Ätzen der freigelegten Abschnitte der Kupferschicht, Spülen, Reinigen und schließlich Trocknen des nun mit den Leiterbahnen aus Kupfer versehenen Trägerelements. Bei zweiseitig zu strukturierenden Leiterplatten sind vor diesen Schritten noch Durchkontaktierungen durch Bohren des Trägerelements zu bilden.

Die Leiterbahnen sowie die zwischenliegenden Flächen des Trägerelements werden nachfolgend durch einen Lötstopplack abgedeckt, der für einen Schutz insbesondere der Kupferschicht vor Korrosion oder mechanischen Einprägungen Sorge trägt und beim anschließenden Löten ein Benetzen der von ihm überzogenen Flächen verhindert. Der Lötstopplack kann aus einem Epoxidharz gebildet sein und Dicken von z.B. 10 - 25 µm aufweisen. In dem Lötstopplack werden Fenster gebildet, die einen Zugang zur darunterliegenden Kupferschicht ermöglichen, so dass ein Kontakt zu nachfolgend zu montierenden elektrischen Komponenten hergestellt werden kann.

Zur Kontaktierung stehen grundsätzlich mehrere Möglichkeiten zur Verfügung, von denen hier nur das Reflow-Löten angeführt sei. Die Fenster bilden Lötflächen bzw. Lötpads aus, auf welche dann Lotpaste bzw. Lötpaste z.B. im Schablonendruck mit Rakel aufgetragen wird. Diese Lotpaste besteht aus einer in Lotkugeln geformten Zinnlegierung und einem Flussmittel. Beim Reflow-Löten werden nach Bestückung mit den elektronischen Komponenten die Lotkugeln geschmolzen, so dass nach Abkühlung eine elektrisch leitfähige Verbindung mit dem Kupfer des Lötpads hergestellt wird.

Gerade in Bezug auf die Verwendung von Kupfer für Leiterbahnen hat sich in letzter Zeit jedoch das Problem gestellt, dass die Kosten für das Rohmaterial am Markt beständig und in großem Maße gestiegen sind. Es wird daher vielerorts dazu übergegangen andere grundsätzlich geeignete Materialien wie insbesondere Aluminium für Leiterbahnen auf Leiterplatten zu verwenden.

Bei der Verwendung von Aluminium stellt sich allerdings wiederum ein besonderes Problem dadurch, dass sich an dessen freiliegender Oberfläche in sehr rascher Zeit nach einer Verarbeitung durch Oxidation eine dünne Schicht aus Aluminiumoxid bildet, die es beispielsweise in dem beschriebenen Reflow-Lötprozess verhindert, dass eine mechanisch stabile und wirksame elektrisch leitfähige Verbindung zwischen dem Aluminium und dem Lot einstellt. Die gebildeten Lotinseln fallen vielmehr leicht von der Oberfläche ab.

Mangels anderer Lösungen ist man daher dazu übergegangen, anstatt von Lotpaste oder Lötzinn elektrisch leitfähige Kleber zu verwenden, um die elektronischen Komponenten mit den Leiterbahnen zu verbinden. Diese sind zwar mechanisch widerstandsfähig, besitzen allerdings nur in eingeschränktem Maße die gewünschten elektrischen Eigenschaften. Ferner beschränken sie die Einsatzfähigkeit hinsichtlich Temperaturbeständigkeit und Dauerhaftigkeit. Allerdings macht der Einsatz von leitfähigem Kleber einen Reflow-Lötprozess leider unmöglich.

Alternativ kann die Oberfläche der Aluminiumbeschichtung durch ein Kupfer enthaltendes Pulver aus einem Plasma heraus mit einer entsprechenden Dünnschicht überzogen werden. Mit dieser wird das Aluminiumoxid entfernt und gleichzeitig eine Oberfläche bereitgestellt, die wieder die nützlichen Anbindungseigenschaften des Kupfers bietet, was Lotpaste oder Lötzinn betrifft.

Dieses Verfahren kann jedoch aufwendig und teuer sein.

### Darstellung der Erfindung

Es ist daher eine Aufgabe, Leiterplatten mit Leiterbahnen einer Aluminiumbeschichtung so weiterzubilden, dass sie eine sichere und verlässliche elektrische Kontaktierung mit zu bestückenden elektrischen Komponenten erlauben und gleichzeitig einen geringen und kostengünstigen Aufwand bei der Herstellung ermöglichen.

Die Aufgabe wird gelöst durch eine Leiterplatte für LED-Module mit den Merkmalen von Patentanspruch 1, durch ein LED-Modul gemäß Anspruch 14 sowie durch eine Verfahren zur Herstellung einer Leiterplatte gemäß Anspruch 16. Vorteilhafte Weiterbildungen der erfindungsgemäßen Schaltungsanordnung sind Gegenstand der abhängigen Ansprüche.

Ausgangspunkt ist eine Leiterplatte für ein LED-Modul, die ein Trägerelement, eine auf dem Trägerelement angeordnete und in Leiterbahnen strukturierte Aluminiumbeschichtung sowie einen Lötstopplack umfasst, der auf oder oberhalb der Aluminiumbeschichtung angeordnet ist und in welchem wenigstens ein Fenster zur Bereitstellung eines Lötpads oder Lötauges ausgebildet ist.

Bei einer solchen Leiterplatte ist nun ein Zinnüberzug vorgesehen, der wenigstens innerhalb oder unterhalb des Fensters im Lötstopplack unmittelbar auf der Aluminiumbeschichtung angeordnet ist. Diese bildet nunmehr das Lötpad aus und ist ferner zur Aufnahme einer Lötpaste oder eines Lötzinns für die Kontaktierung oberflächenmontierbarer Bauelemente ausgebildet. Bei solchen oberflächenmontierbaren Bauelemente handelt es sich beispielsweise um SMD- (Surface Mounted Devices) Bausteine wie etwa LEDs, etc., deren Anschlüsse mit dem Lot verschmolzen werden können.

Wie herausgefunden wurde, können Prozesse, die zur Bildung eines bloßen Zinnüberzugs - im Gegensatz zu dicken schichtartigen Auftrag einer Lotpaste oder eines Lötzinns - das Hindernis der schnellen Bildung einer Aluminiumoxidschicht verhindern oder wenigstes umgehen. Der Zinnüberzug ist in dem Fensterbereich, d.h. auf dem Lötpad vollflächig, und ermöglicht nunmehr mit Vorteil den eigentlich Auftrag der Lotpaste bzw. des Lötzinns und damit die elektrische Anbindung des oberflächenmontierbaren Bauelements. Die Verbindung des Überzugs mit der Oberfläche der Aluminiumbeschichtung ist dabei gleichzeitig mechanisch äußerst stabil.

Ein besonderer Vorteil dieses Aspekts der Erfindung entsteht dadurch, dass durch die Bereitstellung eines Zinnüberzugs zumindest auf den Lötpads der Leiterbahnen die bisher für kupferbasierte Leiterbahnen ausgelegten, folgenden Lötprozessschritte bei der Herstellung selbst in Bezug auf ihre Parameter nahezu beibehalten werden können, denn der Auftrag der Lötpaste auf den nun bereits vorhandenen Zinnüberzug ist problemlos. Der Zinnüberzug ist in absehbarer Zeit kaum einer Korrosion unterworfen. Der Vorteil stellt sich insbesondere beim folgenden Reflow-Löten ein, aber dies gilt auch alternativ für ein etwaiges Wellenlöten etc.

Einer Weiterbildung der Erfindung zufolge ist der Zinnüberzug anhand eines Prozesses der Oberflächenveredelung durch eine Verzinnung einer vorzugsweise freiliegenden Oberfläche der Aluminiumbeschichtung gebildet. Der Prozess kann eine galvanische Verzinnung beinhalten. Der Prozess kann auch einen gleichzeitigen oder vorherigen, mechanischen, physikalischen und/oder chemischen Abtrag des oberflächlichen Aluminiumoxids beinhalten bzw. eine chemische Umwandlung desselben.

Aluminiumoxid ist weitgehend zäh und aufgrund des im Vergleich etwa zu Kupferoxid sehr hohen Schmelzpunkts von rund 2.050 ºC schwierig zu entfernen (Kupfer(I)-oxid: 1.232 ºC, Aluminium selbst: 660,2 ºC). Darüber hinaus ist Aluminiumoxid selbst äußerst korrosionsbeständig. Beispielsweise können aber bei der Verzinnung aggressive Flussmittel eingesetzt werden, etwa aminbasierte (organisch) oder auf Natronlauge basierte (anorganisch) o.ä. Flussmittel sind bei der Benetzung eines Stoffs oder Werkstücks mit zinnhaltigen Materialien (Legierungen) zugegebene Stoffe.

Als Alternative zu Flussmitteln bieten sich insbesondere aber auch Ultraschalllötbäder an. Dabei wird das Aluminiumoxid durch Kavitation von der Oberfläche der Leiterbahn entfernt. Das Zinn trifft dann mit einer vergleichsweise hohen Geschwindigkeit auf die Leiterbahnoberfläche. Der Ultraschall-Schwinger steht dabei in direktem Kontakt mit flüssigem Zinn und überträgt dadurch die kinetische Energie auf das Zinn. Mithin wird die Aluminiumoberfläche vollflächig benetzt - soweit sie freiliegt, während gleichzeitig das Aluminiumoxid aufgebrochen wird. Flussmittel können dabei entbehrlich sein.

Einer Weiterbildung der Erfindung zufolge wird der Zinnüberzug durch Eintauchen des Trägerelements mit zumindest der in Leiterbahnen strukturierten Aluminiumbeschichtung in ein Zinn enthaltendes Bad gebildet. Dadurch wird lediglich benetzender Überzug ermöglicht, der anschließend als Vorbereitung für den Auftrag der Lotpaste dienen kann. Das Bad ermöglicht optional auch den Einsatz galvanischer Verzinnung. Dabei wird die Leiterplatte mit der Oberfläche der Aluminiumbeschichtung in einen Zinnelektrolyt getaucht, und durch Anlegen elektrischer Spannung scheidet sich an der Oberfläche der dünne Zinnüberzug ab. Die Dicke kann wenige µm betragen.

Einer Weiterbildung der Erfindung zufolge bildet der Zinnüberzug aufgrund eines Herstellungsschrittes mit Heißluftverzinnung eine HAL-Oberfläche aus (HAL: Hot Air Levelling bzw. HASL: Hot Air Solder Levelling). Dabei werden die Leiterplatten zunächst in ein Flussmittel und anschließend vollständig in ein Bad (Lottiegel) aus flüssigem Lot (Zinnlegierung) getaucht. Beim oder nach dem Herausziehen der Leiterplatten aus dem Bad bzw. Lottiegel wird überschüssiges Lot mit heißer Luft abgeblasen. Die resultierende Koplanarität der Oberfläche gegenüber der vorherigen Oberfläche der Aluminiumbeschichtung ist durch das Abblasen zwar eher dürftig (starke Schwankungen zwischen 1 µm und 40 bis 50 µm). Die ist jedoch vorliegend hinnehmbar, da es hier nur um eine Verzinnung zur Bildung eines Zinnüberzugs geht, der anschließend in einem weiteren Schritt selbst wieder Lotpaste im Reflow-Lötverfahren oder Lötzinn aufnimmt. Andererseits wird die HAL-Oberfläche als mit bester Lötbarkeit unter den bekannten Oberflächensystemen versehen beschrieben.

Einer weiteren Weiterbildung der Erfindung zufolge besitzt der Zinnüberzug eine Dicke von 1 µm oder mehr und 50 µm oder weniger. Dieser Bereich ist auf vorteilhafte Weise mit HAL-Oberflächen kompatibel. Mögliche weiter eingeschränkte Bereiche sind 1 - 40 µm, 4 - 10 µm oder 5 - 8 µm.

Einer weiteren Weiterbildung der Erfindung zufolge ist der Zinnüberzug auf der Aluminiumbeschichtung ausschließlich innerhalb der Fenster im Lötstopplack angeordnet. Durch dieses mit dem HAL-Verzinnen kompatible Merkmal wird der Zinnüberzug nur dort aufgetragen, wo er benötigt wird, nämlich auf den Lötpads bzw. Lötflächen. Beim HAL-Verzinnen wird die fertige Leiterplatte einschließlich des Lötstopplacks in das Bad eingetaucht. Der Lötstopplack selbst stellt keine dauerhafte Verbindung mit der Zinnlegierung her, das Zinn perlt einfach vom Lötstopplack ab, so dass der Zinnüberzug selektiv nur auf der Oberfläche der Aluminiumbeschichtung stattfindet. Dadurch kann Zinn eingespart werden.

Einer alternativen Weiterbildung der Erfindung zufolge bildet der Zinnüberzug aufgrund eines entsprechenden Herstellungsprozesses eine Chemisch-Zinn-Oberfläche aus. Diese weist im Gegensatz zur HAL-Oberfläche einen hohen Grad an Koplanarität aus und der resultierende Zinnüberzug ist zudem sehr dünn, beispielsweise zwischen 0,7 oder 0,8 µm auf der einen und 1,2 µm auf der anderen Seite einschl. der Randwerte. Dadurch wird ebenfalls viel Zinn eingespart. Beim Chemisch-Zinn-Verfahren, das konventionell zur Verzinnung von Kupferoberflächen eingesetzt wird, wird die Leiterplatte noch ohne den Lötstopplack in eine Lösung eines Zinnsalzes (z.B. Zinnsulfat) mit z.B. Schwefelsäure, Thioharnstoff sowie Glanz- und Netzmitteln eingetaucht. Das Verfahren wird vorzugsweise stromlos durchgeführt.

Ein besonderer Vorteil entsteht dadurch, dass sich eine intermetallische Phase zwischen dem Kupfer und dem Zinn ausbildet. Während des Eintauchens wird der Leiterplatte wird eine oberste Schicht des Metalls der Leiterbahn durch Thioharnstoff bzw. einem analogen, diesbezüglich für Aluminium geeigneten Stoff durch Zinn austauscht. Die intermetallische Phase beeinträchtigt eine Lötfähigkeit des gebildeten Zinnüberzugs an sich (in negativer Hinsicht). Jedoch geht es hier nicht - wie oben beschrieben - um die Lötfähigkeit des Zinnüberzugs, sondern vielmehr um die stabile Aufnahmefähigkeit der nachfolgend aufzutragenden Lotpaste und damit den leitfähigen Übergang vom Aluminium zur Lotpaste, der hier mit besonders guter Qualität gelingt.

Einer weiteren Weiterbildung der Erfindung zufolge besitzt der Zinnüberzug eine Dicke von 0,7 µm oder mehr, vorzugsweise 0,8 µm oder mehr, und 1,2 µm oder weniger. Ein solch dünner Überzug spart Zinn und bietet einen hohen Grad an Glattheit.

Einer weiteren Weiterbildung der Erfindung zufolge ist der Zinnüberzug vollflächig auf der Aluminiumbeschichtung zwischen deren Oberfläche und dem Lötstopplack sowie unterhalb der Fenster im Lötstopplack angeordnet. Dieser Aspekt ist kompatibel mit einer Chemisch-Zinn-Oberfläche, denn im entsprechenden Herstellungsverfahren wird die Leiterplatte noch ohne Lötstopplack in die Zinnsalzlösung eingetaucht, so dass die komplette Leiterbahn aus Aluminium freiliegt.

Einer weiteren Weiterbildung der Erfindung zufolge umfasst die Leiterplatte die Lötpaste oder das Lötzinn, die/das zur Bildung eines Lötpads für die Kontaktierung oberflächenmontierbarer Bauelemente (SMD) in dem Fenster auf dem Zinnüberzug angeordnet ist. Dadurch können in einem Lötverfahren wie dem Reflow-Löten oder dem Wellenlöten gemäß Oberflächenmontagetechnologie (SMT) die oberflächenmontierbaren Bauelemente (SMD) mit der Leiterplatte verbunden werden.

Einer weiteren Weiterbildung der Erfindung zufolge ist das Trägerelement aus einem elektrisch isolierenden Material gebildet, und umfasst vorzugsweise eine mit Epoxidharz getränkte Glasfasermatte, weiter vorzugsweise mit der Materialkennung FR4. Die Erfindung ist aber nicht auf FR4 beschränkt, beispielsweise ist auch verbessertes Material der Kennung FR5 oder es sind andere, einfachere Materialien umfasst, soweit es um starre Leiterplatten geht.

Alternativ sehen Weiterbildungen der Erfindung vor, flexible Folien vorzugsweise aus Polyimid, PET oder anderen für das aus einem elektrisch isolierenden Material gebildete Trägerelement vorzusehen.

Einer weiteren Weiterbildung der Erfindung zufolge ist der Lötstopplack ein photostrukturierbarer Lötstopplack oder alternativ ein nicht photostrukturierbarer Lötstopplack. Gemäß Tintenstrahltechnologie aufgetragene Lötstopplacke sind ebenfalls umfasst. Einem weiteren Aspekt der Erfindung zufolge ist ein LED-Modul vorgeschlagen, das die Leiterplatte wie oben beschrieben umfasst, sowie zumindest ein oberflächenmontierbares Bauelement (SMD), das zur Kontaktierung mit dem aus der Lötpaste oder dem Lötzinn gebildeten Lötpad verbunden ist. Dabei handelt es sich vorzugsweise um eine lichtemittierende Diode (LED), oder um ein elektronisches Bauelement, das in der entsprechenden Schaltungsanordnung verwendet wird.

Einem weiteren Aspekt der Erfindung zufolge ist ein Verfahren zur Herstellung einer Leiterplatte für ein LED-Modul vorgeschlagen. Das Verfahren umfasst die Schritte:
Bereitstellen eines Trägerelements;
Auftragen einer Aluminiumbeschichtung und Strukturieren derselben in Leiterbahnen;
Auftragen eines Lötstopplacks und darin Bilden wenigstens eines Fensters zur Bereitstellung eines Lötpads ausgebildet ist. Kennzeichnend ist dabei folgender Schritt:
   Bilden eines Zinnüberzugs innerhalb des Fensters oder unterhalb des Lötstopplacks unmittelbar auf der Aluminiumbeschichtung zur Aufnahme einer Lötpaste oder eines Lötzinns für die Kontaktierung oberflächenmontierbarer Bauelemente, vorzugsweise durch Verzinnung einer Oberfläche der Aluminiumbeschichtung. Die gleichen oder analogen Vorteile wie oben beschrieben ergeben sich auch aus dem vorgeschlagenen Herstellungsverfahren.

Weitere Vorteile, Merkmale und Einzelheiten der Erfindung ergeben sich aus den Ansprüchen, der nachfolgenden Beschreibung bevorzugter Ausführungsformen sowie anhand der Zeichnungen. In den Figuren bezeichnen gleiche Bezugszeichen gleiche Merkmale und Funktionen.

### Kurze Beschreibung der Zeichnung(en)

Es zeigen:
- Fig.1: einen ausschnittweisen Querschnitt durch eine Leiterplatte in schematischer Darstellung in einem Schritt nach Aufbringen einer Aluminiumschicht;
- Fig. 2: einen ausschnittweisen Querschnitt wie in Fig. 1, jedoch nach einem folgenden Schritt der fotolithografischen Strukturierung der Aluminiumschicht und dem Auftrag eines Lötstopplacks;
- Fig. 3: einen ausschnittweisen Querschnitt wie in Fig. 2, jedoch nach einem weiteren Schritt der Verzinnung in Zusammenhang mit der Bildung einer HAL-Oberfläche als Lötpad gemäß einem ersten Ausführungsbeispiel der Erfindung;
- Fig. 4: einen ausschnittweisen Querschnitt wie in Fig. 3, jedoch nach einem weiteren Schritt des Auftrags einer Lotpaste auf die HAL-Oberfläche der Lötpads;
- Fig. 5: einen ausschnittweisen Querschnitt wie in Fig. 4, jedoch nach Anwendung eines SMD Bestückungs- und Reflow-Lötprozesses gemäß dem ersten Ausführungsbeispiel der Erfindung;
- Fig. 6: einen ausschnittweisen Querschnitt wie in Fig. 1, jedoch nach einen folgenden Schritt der fotolithografischen Strukturierung der Aluminiumschicht und anschließender Verzinnung der strukturierten Aluminiumschicht gemäß einem zweiten Ausführungsbeispiel der Erfindung;
- Fig. 7: einen ausschnittweisen Querschnitt wie in Fig. 6, jedoch nach einen folgenden Schritt des Auftrags eines Lötstopplacks;
- Fig. 8: einen ausschnittweisen Querschnitt wie in Fig. 7, jedoch nach einen folgenden Schritt des Auftrags einer Lotpaste auf die Chemisch-Zinn-Oberfläche der Lötpads;
- Fig. 9: einen ausschnittweisen Querschnitt wie in Fig. 8, jedoch nach Anwendung eines Reflow-Lötprozesses mit fertigem LED-Modul gemäß dem zweiten Ausführungsbeispiel der Erfindung.

### Bevorzugte Ausführungsform(en) der Erfindung

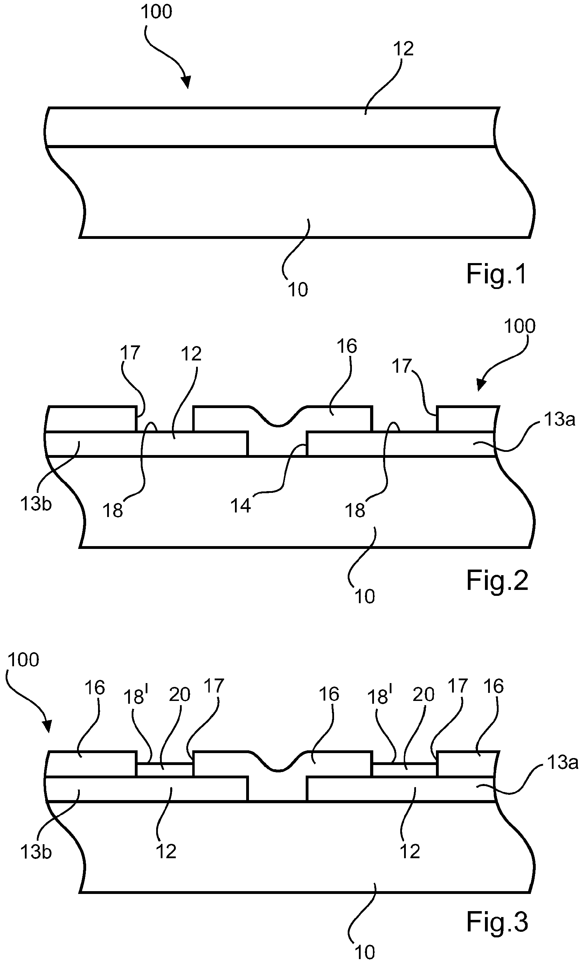

In den Fig. 1 bis 5 ist anhand von schematischen und ausschnittsweisen Querschnitten der Ablauf eines Verfahrens gezeigt, das der Herstellung einer Leiterplatte 100 bzw. eines LED-Moduls 200 gemäß einem ersten Ausführungsbeispiel der Erfindung dient. Fig. 1 zeigt dabei ein Trägerelement 10, auf dem eine Aluminiumbeschichtung 12 vollflächig (hier nur auf einer Seite des Trägerelements 10) aufgebracht ist. Das Trägerelement 10 ist in diesem Ausführungsbeispiel starr und das Material umfasst in Epoxidharz getränktes Glasfasergewebe der Materialkennungen FR4 oder FR5 (FR steht für: flame retardant, d.h. Wärmebeständigkeit). Ohne Beschränkung der Allgemeinheit beträgt die Dicke des Trägerelements 10 hier z.B. 0,80 mm bis 3,20 mm. Die Dicke der Aluminiumbeschichtung 12 beträgt z.B. 35 µm.

In Fig. 2 ist der Zustand nach fotolithographischer Strukturierung der Aluminiumbeschichtung 12 und Auftrag eines Lötstopplacks 16 ergibt. Die Aluminiumbeschichtung 12 wird dabei beispielsweise zuerst mit einem Resist überzogen (nicht gezeigt) bzw. laminiert, der dann gemäß einem vorgegebenen Layout der jeweils zu bildenden Schaltungsanordnung belichtet wird. Je nachdem, ob ein Negativ- oder Positivresist verwendet wird, werden die belichteten oder unbelichteten Teile in einem Entwicklerschritt entfernt. Es bleibt eine Resistmaske stehen, anhand der die unterliegende Aluminiumbeschichtung 12 in einem Ätzschritt strukturiert wird, so dass nur solche dem Layout entsprechenden Leiterbahnen 13a, 13b in der Aluminiumbeschichtung 12 stehen blieben und durch Öffnungen oder Spalte 14 voneinander getrennt sind. Die Leiterplatte 100 wird anschließend gespült und getrocknet.

Auf die so strukturierte Oberfläche des Trägerelements 10 bzw. der Leiterbahnen 13a, 13b der Aluminiumbeschichtung 12 wird als nächstes ein Lötstopplack 16 aufgetragen. Die Schichtdicke des Lötstopplacks kann beispielsweise 20 bis 45 µm auf dem FR4- oder FR5-Material des Trägerelements 10 der Leiterplatte 100 betragen, 10 bis 25 µm auf den Leiterbahnen 13a, 13b, wobei davon nur 5 µm oder mehr zumindest auf den Kanten der Leiterbahnen (dort leicht gedünnt) übrig bleiben. Der Lötstopplack 16 kann zur Ausbildung von Fenstern 17 beispielsweise im Siebdruck- oder im Sprühverfahren aufgetragen werden. Laminieren von Photopolymerfolien ist ebenso möglich, etc. Es kann sich um photostrukturierbare Lötstopplacke oder um nicht-photostrukturierbare Lötstopplacke handeln. Erstere werden ähnlich wie oben mit Bezug auf den Fotoresist für die Bildung der Leiterbahnen belichtet, entwickelt, und gespült. Durch diese Schritte werden Fenster 17 im Lötstopplack 16 gebildet, die wiederum Lötaugen bzw. Lötflächen oder Lötpads 18 auf den darunterliegenden Leiterbahnen 13a, 13b der Aluminiumbeschichtung 12 freilegen. Der verwendete Lötstopplack ist konventionell und kann beispielsweise eine grüne Farbe besitzen. Der Lötstopplack wird nach dieser Strukturierung nicht weiter bearbeitet und bleibt auf dem fertigen Produkt stehen. Er dient unter anderem dem Korrosionsschutz und zur Erhöhung der Durchschlagsfestigkeit, sowie insbesondere für die nachfolgenden Lötschritte als Oberfläche, an der erstarrte Zinnlegierungen nicht anhaften, so dass Zinn einerseits eingespart und andererseits dabei auf die Fenster 17 bzw. Lötpads 18, 18' fokussiert werden kann. Der Lötstopplack kann auf einem Epoxidharz basieren.

Es ist anzumerken, dass hier durchaus auch die Tintenstrahltechnologie zur Bildung des Lötstopplacks 16 einsetzbar ist.

In Fig. 3 ist der Zustand nach Durchführung einer Verzinnung der freiliegenden Oberflächen der Leiterbahnen 13a, 13b in den Fenstern 17 bzw. auf den Lötpads 18 gezeigt. Der für dieses erste Ausführungsbeispiel durchgeführte Prozess ist das Hot Air Leveling (HAL). Dabei werden die Leiterplatten zunächst in ein Flussmittel und anschließend vollständig in ein Bad, d.h. einem Lottiegel aus flüssigem Lot getaucht. Das Lot enthält die geschmolzene Zinnlegierung, wobei Blei enthalten sein kann oder auch nicht (um z.B. der RoHS-Richtlinie 2011/65/EU der Europäischen Union zu entsprechen). Die Erfindung ist nicht auf spezielle Zinnlegierungen beschränkt.

Beim oder nach dem Herausziehen der Leiterplatten aus dem Bad bzw. dem Lottiegel wird überschüssiges Lot mit heißer Luft abgeblasen. Der Luftstrom, -druck und - temperatur sind so eingestellt, dass ein möglichst glatter Auftrag gelingt. HAL-Prozesse sind in Zusammenhang mit der Verzinnung von Kupferoberflächen hinreichend bekannt, so dass auf eine detaillierte Beschreibung verzichtet und vielmehr auf die einschlägige Literatur verwiesen werden kann. Für die Anwendung auf Aluminium ist das Verfahren ggf. anzupassen, indem im Hinblick auf das Aufbrechen des bei Aluminium sehr schnell durch Oxidation entstehenden Oberflächenüberzugs aus Aluminiumoxid gerade jene Oberfläche unmittelbar vorab einer Behandlung unterzogen wird, etwa durch den Einsatz geeigneter, insbesondere aggressiver Flussmittel.

Für das Löten von Aluminium im Allgemeinen sind spezielle Flussmittel bekannt, die säurehaltig sind und die Verunreinigung unmittelbar an der Lötstelle eliminieren (wie es zum Beispiel vom Zinkchlorid her bekannt ist). Solche Flussmittel sind sogar in der Lage, anschließend Rückstände von der Lötstelle zu entfernen. Ein Anbieter solcher rückstandsfreier Flussmittel ist u.a. beispielsweise die Almit GmbH, Michelstadt, Deutschland.

Der aus diesem HAL-Prozess resultierende Zinnüberzug 20 liegt nun ausschließlich innerhalb des jeweiligen Fensters 17 vor, da er nicht auf dem Lötstopplack 16 anhaftet. Er besitzt in diesem Ausführungsbeispiel z.B. eine Dicke zwischen 1 und 50 µm, vorzugsweise zwischen 4 und 8 µm. Das HAL-verfahren besitzt den Vorteil, besonders kostengünstig zu sein und gleichzeitig eine besonders hervorragende Lötbarkeit anzubieten. Es wurde festgestellt, dass durch diese Anwendung der Verzinnung der Aluminiumoberfläche diese vor weiterer Oxidation geschützt wird, während nachfolgende Lötschritte lediglich eine Zinnlegierung in Kontakt mit dem Zinnüberzug bringen müssen, welches selbstredend wenig Probleme im Hinblick auf eine Harmonisierung der betroffenen Stoffe mit sich bringt. Die Lötpads 18' werden in diesem Ausführungsbeispiel nun also durch eine HAL-verzinnte Oberfläche und nicht mehr durch eine Aluminiumoberfläche gebildet. Dadurch kann nachfolgend auf elektrisch leitfähige Kleber zur Kontaktierung der elektronischen Bauelemente (SMDs) verzichtet werden, denn der Einsatz von Lotpaste wird möglich.

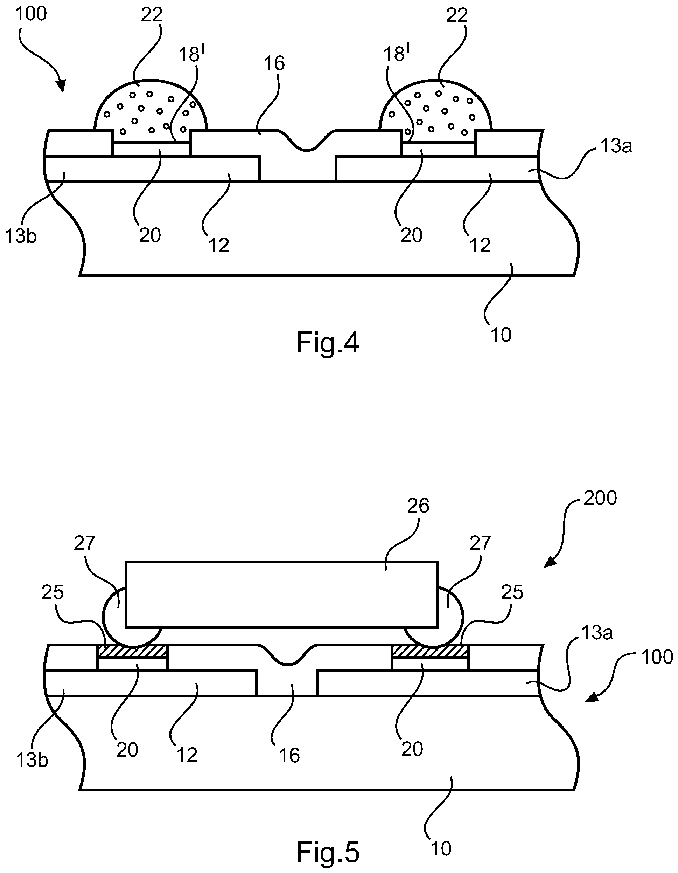

In Fig. 4 ist der Zustand der Leiterplatte 100 nach Auftrag einer Lotpaste 22 durch Schablonendruck gezeigt. Die Lotpaste 22 umfasst eine viskose, eher noch pastöse Mischung aus einem Lotmetallpulver bzw. kleinsten Lotkügelchen und einem Flussmittel. Das hierbei verwendete Flussmittel (Massenanteil z.B. 10 %) ermöglicht die Verbindung zwischen dem Lot und dem zu verbindenden elektronischen Bauteil, hier z.B. einem als LED ausgebildeten oberflächenmontierbaren Bauelements (SMD) 26. Flussmittel dienen dazu, oberflächliche Oxide durch chemische Reaktionen zu entfernen und neu auftretende Oxide aus der Verbindung von Luftsauerstoff mit Wärme zu unterbinden. Ferner tragen Flussmittel dazu bei eine Schutzschicht zu bilden und letztlich verringern sie die Oberflächenspannung des flüssigen Lotes. Der flüchtige Anteil des Flussmittels verdampft beim Lötprozess.

In Fig. 5 ist der Zustand nach dem Anbringen (Bestücken, pick-and-place) des oberflächenmontierbaren Bauelements (SMD) 26 und dem Reflow-Löten (Wiederaufschmelz-Löten) gezeigt. Das SMD 26 besitzt Kontakte 27 bzw. "Beinchen", die in die Lötpaste 22 gedrückt wurden. Durch die Eigenschaften des Flussmittels sammelt sich diese außen um die nunmehr aufgeschmolzene Masse des Lots 25 herum, das sich wiederum selbst auf das Lötpad 18' auf dem Zinnüberzug 20 zieht. Fig. 5 zeigt mithin einen Ausschnitt des fertigen LED-Moduls 200.

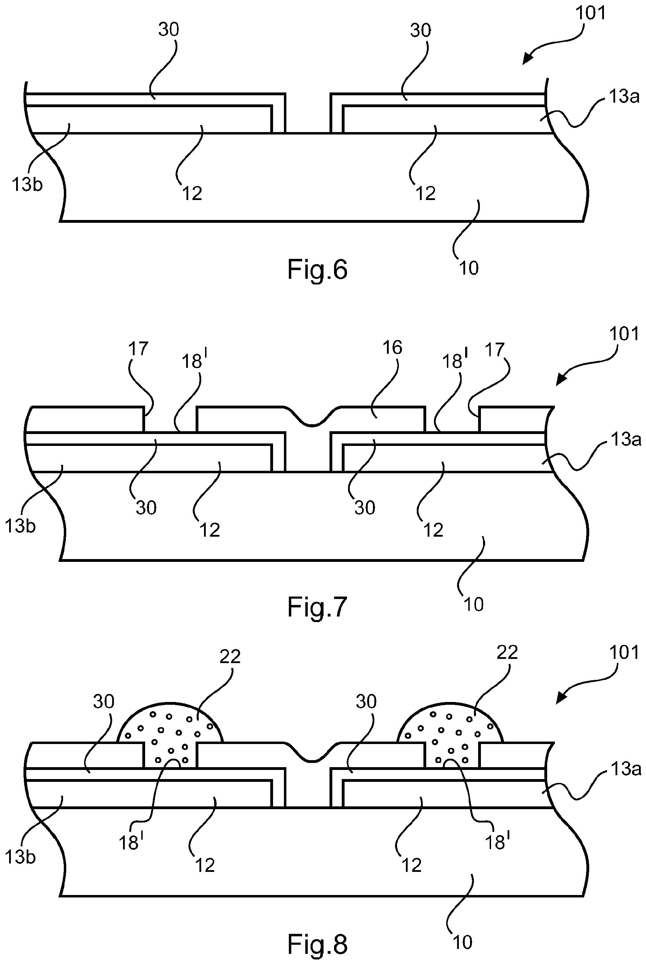

Ein zweites Ausführungsbeispiel der vorliegenden Erfindung wird anhand des in den Fig. 6 bis 9 illustrierten Herstellungsverfahrens erläutert. Ausgangspunkt ist der in Fig. 1 gezeigte Zustand.

In Fig. 6 ist ein Zustand der nunmehr mit dem Bezugszeichen 101 bezeichneten Leiterplatte gezeigt, bei dem nach der fotolithografischen Strukturierung - ähnlich wie mit Bezug auf Fig. 2 beschrieben - aber noch vor dem Auftrag des Lötstopplacks auf den Leiterbahnen 13a, 13b der Aluminiumbeschichtung 12 ein sehr dünner Zinnüberzug 30 gebildet wird. Dieser bildet sich mangels Lötstopplacks vollflächig und gegebenenfalls auf den Seitenflächen der Leiterbahnen 13a, 13b, wie in Fig. 6 zu sehen ist. Das im zweiten Ausführungsbeispiel durchgeführte Verfahren der Verzinnung entspricht einem Chemisch-Zinn-Prozess. Die Dicke des durch Verzinnung der Aluminiumbeschichtung entstandenen Zinnüberzugs 30 beträgt hier nur 0,7 oder 0,8 µm bis 1,2 oder 1,3 µm.

Beim Chemisch-Zinn-Verfahren wird die Leiterplatte 101 in eine Lösung eines Zinnsalzes (z.B. Zinnsulfat) mit z.B. Schwefelsäure, Thioharnstoff sowie Glanz- und Netzmitteln eingetaucht. Das Verfahren wird vorzugsweise stromlos durchgeführt, kann jedoch hier auch mit Vorteil mit einem galvanischen Verfahren kombiniert werden. Mit Vorteil bildet sich hierbei eine intermetallische Phase zwischen dem Kupfer und dem Zinn aus. Während des Eintauchens der Leiterplatte 101 wird eine oberste Schicht des Metalls der Leiterbahn durch Thioharnstoff bzw. einem analogen, diesbezüglich für Aluminium geeigneten Stoff durch Zinn austauscht.

Die nachfolgenden Schritte, wie sie in den Fig. 7 - 9 gezeigt sind, sind analog zu den in den Fig. 2, 4 und 5 gezeigten Schritten. In Fig. 7 ist der Auftrag des Lötstopplacks 16 gezeigt, in welchem Fenster 17 zur Freistellung von Lötpads 18' über der Verzinnung gebildet sind. Die Lötpads 18' werden nun also durch eine Chemisch-Zinn-Oberfläche und nicht mehr durch eine Aluminiumoberfläche gebildet.

In Fig. 8 ist der anschließende Auftrag der Lotpaste 22 gezeigt. Die Schritte werden ähnlich oder gleich durchgeführt wie oben beschrieben, so dass auf eine Wiederholung der Beschreibung derselben verzichtet wird.

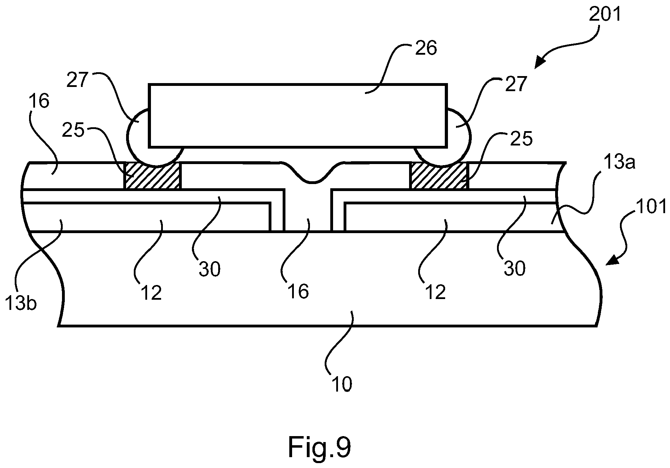

In Fig. 9 ist in dem ausschnittsweisen Querschnitt der fertige Zustand des LED-Moduls 200' mit Leiterplatte 101 und aufgeprägtem oberflächenmontierbaren Bauelement (SMD) 26 gezeigt, dessen Kontakte 27 bzw. "Beinchen" im nun wieder verfestigten Lot bzw. der Lötstelle 25 fixiert sind.

Verschiedene Modifikationen der beschrieben Ausführungsbeispiele sind möglich soweit sie vom Umfang der beigefügten Ansprüche umfasst sind. So können anstatt der gezeigten Trägerelemente 10 aus FR4 oder FR5-Materialien insbesondere auch dünne flexible Folien aus Polyimid oder PET (Polyethlyen) als Trägerelemente 10 verwendet und eingesetzt werden. Die Erfindung ist diesem Fall besonders vorteilhaft.

### BEZUGSZEICHENLISTE:

- 10: Trägerelement
- 12: Aluminiumbeschichtung
- 13a, 13b: Leiterbahnen
- 14: Spalt zwischen Leiterbahnen
- 16: Lötstopplack
- 17: Fenster im Lötstopplack
- 18: Lötauge / Lötpad (Aluminium)
- 18': Lötauge / Lötpad (Zinnüberzug)
- 20: Zinnüberzug (HAL-Oberfläche)
- 22: Lotpaste
- 25: Lot bzw. Lötstelle
- 26: SMD (LED)
- 27: Kontakt, "Beinchen"
- 30: Zinnüberzug (Chemisch Zinn)
- 100: Leiterplatte (1. Ausführungsbeispiel)
- 101: Leiterplatte (2. Ausführungsbeispiel)
- 201: LED-Modul (1. Ausführungsbeispiel)
- 200: LED-Modul (2. Ausführungsbeispiel)

## Patentansprüche

1. Leiterplatte (100, 101) für ein LED-Modul, umfassend:
ein Trägerelement (10);
eine auf dem Trägerelement (10) angeordnete und in Leiterbahnen (13a, 13b) strukturierte Aluminiumbeschichtung (12);
einen Lötstopplack (16), der auf oder oberhalb der Aluminiumbeschichtung (12) angeordnet ist und in welchem wenigstens ein Fenster (17) zur Bereitstellung eines Lötpads (18') ausgebildet ist,
**gekennzeichnet durch**
einen Zinnüberzug (20, 30), der innerhalb des Fensters (17) im Lötstopplack (16) oder vollflächig unterhalb des Lötstopplacks (16) unmittelbar auf der Aluminiumbeschichtung (12) angeordnet und als Lötpad (18') zur Aufnahme einer Lotpaste (22) oder eines Lötzinns für die Kontaktierung oberflächenmontierbarer Bauelemente (26) während der Herstellung ausgebildet ist.

2. Leiterplatte (100, 101) gemäß Anspruch 1, wobei
der Zinnüberzug (20, 30) anhand eines Prozesses der Oberflächenveredelung durch eine Verzinnung einer Oberfläche der Aluminiumbeschichtung (12) gebildet ist.

3. Leiterplatte (100, 101) gemäß Anspruch 1 oder 2, wobei
der Zinnüberzug (20, 30) durch Eintauchen des Trägerelements mit zumindest der in Leiterbahnen (13a, 13b) strukturierten Aluminiumbeschichtung (12) in ein Zinn enthaltendes Bad gebildet ist.

4. Leiterplatte (100) gemäß einem der Ansprüche 1 bis 3, wobei
der Zinnüberzug (20) aufgrund eines Herstellungsschrittes mit Heißluftverzinnung eine HAL-Oberfläche ausbildet.

5. Leiterplatte (100) gemäß einem der Ansprüche 1 bis 4, wobei
der Zinnüberzug (20) eine Dicke von 1 µm oder mehr und 50 µm oder weniger besitzt.

6. Leiterplatte (100) gemäß einem der Ansprüche 1 bis 5, wobei
der Zinnüberzug (20) auf der Aluminiumbeschichtung (12) ausschließlich innerhalb des Fensters (17) angeordnet ist.

7. Leiterplatte (101) gemäß Anspruch 1 oder 2, wobei
der Zinnüberzug (30) aufgrund eines entsprechenden Herstellungsprozesses eine Chemisch-Zinn-Oberfläche ausbildet.

8. Leiterplatte (101) gemäß einem der Ansprüche 1, 2 oder 7, wobei
der Zinnüberzug (30) eine Dicke von 0,8 µm oder mehr und 1,2 µm oder weniger besitzt.

9. Leiterplatte (101) gemäß einem der Ansprüche 1, 2, 7 oder 8, wobei
der Zinnüberzug (30) vollflächig auf der Aluminiumbeschichtung (12) zwischen deren Oberfläche und dem Lötstopplack (16) im Lötstopplack (16) angeordnet ist.

10. Leiterplatte (100, 101) gemäß einem der vorhergehenden Ansprüche, ferner umfassend:
die Lötpaste (22) oder das Lötzinn, die/das für die Kontaktierung oberflächenmontierbarer Bauelemente in dem Fenster (17) auf dem durch den Zinnüberzug (20, 30) gebildeten Lötpad (18') angeordnet ist.

11. Leiterplatte (100, 101) gemäß einem der vorhergehenden Ansprüche, wobei
das Trägerelement (10) aus einem elektrisch isolierenden Material gebildet ist, und vorzugsweise eine mit Epoxidharz getränkte Glasfasermatte, weiter vorzugsweise mit der Materialkennung FR4 oder FR5, umfasst.

12. Leiterplatte (100, 101) gemäß einem der Ansprüche 1 bis 10, wobei
das Trägerelement (10) aus einem elektrisch isolierenden Material gebildet ist, und als flexible Folie vorzugsweise aus Polyimid oder PET gebildet ist.

13. Leiterplatte (100, 101) gemäß einem der vorhergehenden Ansprüche, wobei
der Lötstopplack (16) ein photostrukturierbarer Lötstopplack oder ein nicht photostrukturierbarer Lötstopplack ist.

14. LED-Modul (200, 201), umfassend die Leiterplatte (100, 101) gemäß einem der Ansprüche 1 bis 13 sowie das auf dem Lötpad (18') angeordnete Lot und zumindest ein oberflächenmontierbares Bauelement (26), das zur Kontaktierung mit dem Lot verbunden ist.

15. LED-Modul gemäß Anspruch 14, wobei das oberflächenmontierbare Bauelement (26) eine lichtemittierende Diode umfasst.

16. Verfahren zur Herstellung einer Leiterplatte (100, 101) für ein LED-Modul (200, 201), umfassend:
Bereitstellen eines Trägerelements (10);
Auftragen einer Aluminiumbeschichtung (12) und Strukturieren derselben in Leiterbahnen (13a, 13b);
Auftragen eines Lötstopplacks (16) und darin Bilden wenigstens eines Fensters (17) zur Bereitstellung eines Lötpads (18'),
**gekennzeichnet durch** den Schritt:
Bilden eines Zinnüberzugs (20, 30) innerhalb oder unterhalb des Fensters (17) im Lötstopplack (16) unmittelbar auf der Aluminiumbeschichtung (12) zur Aufnahme einer Lötpaste (22) oder eines Lötzinns für die Kontaktierung oberflächenmontierbarer Bauelemente (26), vorzugsweise durch Verzinnung einer Oberfläche der Aluminiumbeschichtung (12).
